(19) Europäisches Patentamt / European Patent Office / Office européen des brevets

(11) **EP 3 295 484 B1**

(12) **EUROPEAN PATENT SPECIFICATION**

(45) Date of publication and mention of the grant of the patent:
**26.08.2020 Bulletin 2020/35**

(51) Int Cl.:
***H01L 29/15*** *(2006.01)*

(21) Application number: **16728814.1**

(22) Date of filing: **01.06.2016**

(86) International application number:
**PCT/US2016/035223**

(87) International publication number:
**WO 2016/196600 (08.12.2016 Gazette 2016/49)**

(54) **METHOD FOR MAKING ENHANCED SEMICONDUCTOR STRUCTURES IN SINGLE WAFER PROCESSING CHAMBER WITH DESIRED UNIFORMITY CONTROL**

VERFAHREN ZUR HERSTELLUNG VON VERBESSERTEN HALBLEITERSTRUKTUREN IN EINER EINZELWAFERBEHANDLUNGSKAMMER MIT GEWÜNSCHTER GLEICHFÖRMIGKEITSKONTROLLE

PROCÉDÉ DE FABRICATION DE STRUCTURES SEMI-CONDUCTRICES AMÉLIORÉES DANS UNE CHAMBRE DE TRAITEMENT DE TRANCHE UNIQUE AVEC RÉGULATION D'UNIFORMITÉ VOULUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **02.06.2015 US 201562169885 P**

(43) Date of publication of application:
**21.03.2018 Bulletin 2018/12**

(73) Proprietor: **Atomera Incorporated**
**Los Gatos, CA 95032 (US)**

(72) Inventors:
• **MEARS, Robert, J.**
**Wellesley, MA 02482 (US)**
• **CODY, Nyles**
**Tempe, AZ 85284 (US)**
• **STEPHENSON, Robert, John**
**Duxford, Cambridgeshire CB22 4PS (GB)**

(74) Representative: **Style, Kelda Camilla Karen**
**Page White & Farrer**
**Bedford House**
**John Street**
**London, WC1N 2BF (GB)**

(56) References cited:
**WO-A1-2015/077580 US-A1- 2007 197 006**

• **KEIM E G ET AL: "Adsorption of atomic oxygen (N2O) on a clean Si(100) surface and its influence on the surface state density; A comparison with O2", SURFACE SCIENCE, NORTH-HOLLAND, AMSTERDAM, NL, vol. 180, no. 2-3, 2 February 1987 (1987-02-02), pages 565-598, XP025746567, ISSN: 0039-6028, DOI: 10.1016/0039-6028(87)90226-3 [retrieved on 1987-02-02]**
• **LAU ET AL: "Evidence that N2O is a stronger oxidizing agent than O2 for both Ta2O5 and bare Si below 1000<o>C and temperature for minimum low-K interfacial oxide for high-K dielectric on Si", MICROELECTRONICS AND RELIABILITY, ELSEVIER SCIENCE LTD, GB, vol. 47, no. 2-3, 1 February 2007 (2007-02-01), pages 429-433, XP005870130, ISSN: 0026-2714, DOI: 10.1016/J.MICROREL.2006.05.018**
• **LUCOVSKY G ET AL: "Low temperature plasma-assisted oxidation and thin-film deposition processes for forming device-quality SiO"2/Si and composite dielectric-SiO"2/Si heterostructures", THIN SOLID FILMS, ELSEVIER-SEQUOIA S.A. LAUSANNE, CH, vol. 220, no. 1-2, 20 November 1992 (1992-11-20), pages 38-44, XP026059893, ISSN: 0040-6090, DOI: 10.1016/0040-6090(92)90545-M [retrieved on 1992-11-20]**

**(Cont. next page)**

- TSU R: "Phenomena in silicon nanostructure devices", APPLIED PHYSICS A MATERIALS SCIENCE & PROCESSING, SPRINGER BERLIN HEIDELBERG, BERLIN/HEIDELBERG, vol. 71, no. 4, 6 September 2000 (2000-09-06), pages 391-402, XP002314003, ISSN: 0947-8396
- UNO K ET AL: "XPS study of the oxidation process of Si(111) via photochemical decomposition of N"2O by an UV excimer laser", SURFACE SCIENCE, NORTH-HOLLAND, AMSTERDAM, NL, vol. 193, no. 3, 1 January 1988 (1988-01-01), pages 321-335, XP024656815, ISSN: 0039-6028, DOI: 10.1016/0039-6028(88)90439-6 [retrieved on 1988-01-01]
- XUAN LUO ET AL: "Chemical design of direct-gap light-emitting silicon", PHYSICAL REVIEW LETTERS, AMERICAN PHYSICAL SOCIETY, US, vol. 89, no. 7, 12 August 2002 (2002-08-12), pages 76802/1-4, XP002357977, ISSN: 0031-9007

## Description

## Technical Field

The present disclosure generally relates to semiconductor devices and, more particularly, to methods for making enhanced semiconductor structures.

## Background

Structures and techniques have been proposed to enhance the performance of semiconductor devices, such as by enhancing the mobility of the charge carriers. For example, U.S. Patent Application No. 2003/0057416 to Currie et al. discloses strained material layers of silicon, silicon-germanium, and relaxed silicon and also including impurity-free zones that would otherwise cause performance degradation. The resulting biaxial strain in the upper silicon layer alters the carrier mobilities enabling higher speed and/or lower power devices. Published U.S. Patent Application No. 2003/0034529 to Fitzgerald et al. discloses a CMOS inverter also based upon similar strained silicon technology.

U.S. Patent No. 6,472,685 B2 to Takagi discloses a semiconductor device including a silicon and carbon layer sandwiched between silicon layers so that the conduction band and valence band of the second silicon layer receive a tensile strain. Electrons having a smaller effective mass, and which have been induced by an electric field applied to the gate electrode, are confined in the second silicon layer, thus, an n-channel MOSFET is asserted to have a higher mobility.

U.S. Patent No. 4,937,204 to Ishibashi et al. discloses a superlattice in which a plurality of layers, less than eight monolayers, and containing a fractional or binary or a binary compound semiconductor layer, are alternately and epitaxially grown. The direction of main current flow is perpendicular to the layers of the superlattice.

U.S. Patent No. 5,357,119 to Wang et al. discloses a Si-Ge short period superlattice with higher mobility achieved by reducing alloy scattering in the superlattice. Along these lines, U.S. Patent No. 5,683,934 to Candelaria discloses an enhanced mobility MOSFET including a channel layer comprising an alloy of silicon and a second material substitutionally present in the silicon lattice at a percentage that places the channel layer under tensile stress.

U.S. Patent No. 5,216,262 to Tsu discloses a quantum well structure comprising two barrier regions and a thin epitaxially grown semiconductor layer sandwiched between the barriers. Each barrier region consists of alternate layers of SiO2/Si with a thickness generally in a range of two to six monolayers. A much thicker section of silicon is sandwiched between the barriers.

An article entitled "Phenomena in silicon nanostructure devices" also to Tsu and published online September 6, 2000 by Applied Physics and Materials Science & Processing, pp. 391-402 discloses a semiconductor-atomic superlattice (SAS) of silicon and oxygen. The Si/O superlattice is disclosed as useful in a silicon quantum and light-emitting devices. In particular, a green electromuminescence diode structure was constructed and tested. Current flow in the diode structure is vertical, that is, perpendicular to the layers of the SAS. The disclosed SAS may include semiconductor layers separated by adsorbed species such as oxygen atoms, and CO molecules. The silicon growth beyond the adsorbed monolayer of oxygen is described as epitaxial with a fairly low defect density. One SAS structure included a 1.1 nm thick silicon portion that is about eight atomic layers of silicon, and another structure had twice this thickness of silicon. An article to Luo et al. entitled "Chemical Design of Direct-Gap Light-Emitting Silicon" published in Physical Review Letters, Vol. 89, No. 7 (August 12, 2002) further discusses the light emitting SAS structures of Tsu.

Published International Application WO 02/103,767 A1 to Wang, Tsu and Lofgren, discloses a barrier building block of thin silicon and oxygen, carbon, nitrogen, phosphorous, antimony, arsenic or hydrogen to thereby reduce current flowing vertically through the lattice more than four orders of magnitude. The insulating layer/barrier layer allows for low defect epitaxial silicon to be deposited next to the insulating layer.

Published Great Britain Patent Application 2,347,520 to Mears et al. discloses that principles of Aperiodic Photonic Band-Gap (APBG) structures may be adapted for electronic bandgap engineering. In particular, the application discloses that material parameters, for example, the location of band minima, effective mass, etc., can be tailored to yield new aperiodic materials with desirable band-structure characteristics. Other parameters, such as electrical conductivity, thermal conductivity and dielectric permittivity or magnetic permeability are disclosed as also possible to be designed into the material.

US2007/197006A1 discloses a method for making a semiconductor device comprising a lattice matching layer.

Despite the advantages provided by such structures, further developments may be desirable for integrating advanced semiconductor materials in various semiconductor devices and for different semiconductor processing configurations.

## Summary

A method for processing a semiconductor wafer in a single wafer processing chamber includes heating the single wafer processing chamber to a temperature in a range of 650-700°C, and forming at least one superlattice on the semiconductor wafer within the heated single wafer processing chamber by depositing silicon and oxygen to form a plurality of stacked groups of layers. Each group of layers includes a plurality of stacked base silicon monolayers defining a base silicon portion and at least one oxygen monolayer constrained within a crystal lattice of adjacent base silicon portions. Depositing the oxygen comprises depositing the oxygen using an $N_2O$ gas flow.

More particularly, the $N_2O$ gas flow may comprise 0.1% to 10% $N_2O$ in a gas comprising at least one of He and Ar, for example. Also by way of example, depositing the oxygen may include depositing the oxygen with an exposure time in a range of 1 to 100 seconds. In one example embodiment, the $N_2O$ gas flow may be in a range of 10 to 5000 standard cubic centimeters per minute (SCCM). Furthermore, the oxygen may be deposited at a pressure in a range of 10 to 100 Torr, for example. Also by way of example, a total dose of $N_2O$ may be in a range of $1\times10^{14}$ to $7\times10^{14}$ atoms/cm$^2$ during the oxygen monolayer formation.

In accordance with one example implementation, the semiconductor wafer may include a plurality of spaced apart shallow trench isolation (STI) regions, and forming the at least one superlattice may include selectively forming a respective superlattice between adjacent pairs of STI regions. In accordance with another example, forming the at least one superlattice may comprise a blanket superlattice formation on the semiconductor wafer. Furthermore, at least some silicon atoms from opposing base silicon portions may be chemically bound together through the at least one oxygen monolayer therebetween.

## Brief Description of the Drawings

FIG. 1 is a greatly enlarged schematic cross-sectional view of a superlattice for use in a semiconductor device manufactured in accordance with the present invention.

FIG. 2 is a perspective schematic atomic diagram of a portion of the superlattice shown in FIG. 1.

FIG. 3 is a greatly enlarged schematic cross-sectional view of another embodiment of a superlattice manufactured in accordance with the invention.

FIG. 4A is a graph of the calculated band structure from the gamma point (G) for both bulk silicon as in the prior art, and for the 4/1 Si/O superlattice as shown in FIGS. 1-2.

FIG. 4B is a graph of the calculated band structure from the Z point for both bulk silicon as in the prior art, and for the 4/1 Si/O superlattice as shown in FIGS. 1-2.

FIG. 4C is a graph of the calculated band structure from both the gamma and Z points for both bulk silicon as in the prior art, and for the 5/1/3/1 Si/O superlattice as shown in FIG. 3.

FIG. 5 is a schematic block diagram of a single wafer processing chamber for superlattice formation using an $N_2O$ gas flow in accordance with an example embodiment.

FIG. 6 is a schematic block diagram of a batch wafer processing chamber for superlattice formation using an $N_2O$ gas flow in accordance with another example useful for understanding the invention.

FIG. 7 is a graph of total dose vs. flow for an $O_2$ oxygen deposition approach and for an $N_2O$ oxygen deposition approach in accordance with an example embodiment in a single wafer processing chamber.

FIG. 8 is a graph of total dose vs. time for an $N_2O$ oxygen deposition approach in accordance with an example embodiment in a single wafer processing chamber.

FIG. 9 is graph of total dose vs. temperature for an $N_2O$ oxygen deposition approach in accordance with an example embodiment in a single wafer processing chamber.

FIGS. 10 and 11 are graphs illustrating concentrations vs. depth for selective superlattice depositions in a single wafer processing chamber in accordance with example embodiments for different STI spacings.

## Detailed Description

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout, and prime notation is used to indicate similar elements in different embodiments.

Generally speaking, the present disclosure relates to enhanced semiconductor devices, particularly those incorporating advanced semiconductor materials such as the superlattice **25** described further below, and associated fabrication techniques. Applicant has established by atomistic simulation and experimental verification (SIMS) that electrical dopants such as boron and arsenic have an energetic minimum close to (e.g., typically one silicon bond removed from) an oxygen (or CO or N, etc.) atomic layer(s) in the superlattice **25**, and preferentially accumulate in this position under thermal diffusion. Following the description of example superlattice structures below, techniques for enhanced deterministic doping of the superlattice **25** are also provided. However, it should be noted that the techniques set forth herein may also be used for other semiconductor layers and structures as well in addition to the noted superlattices, as will be appreciated by those skilled in the art.

Applicants theorize, without wishing to be bound thereto, that certain superlattices as described herein reduce the effective mass of charge carriers and that this thereby leads to higher charge carrier mobility. Effective mass is described with various definitions in the literature. As a measure of the improvement in effective mass Applicants use a "conductivity reciprocal effective mass tensor", $\mathbf{M}_e^{-1}$ and $\mathbf{M}_h^{-1}$ for electrons and holes respectively, defined as:

$$\mathbf{M}_{e,ij}^{-1}(E_F,T) = \frac{\sum\limits_{E>E_F}\int\limits_{B.Z.}\left(\nabla_{\mathbf{k}}E(\mathbf{k},n)\right)_i\left(\nabla_{\mathbf{k}}E(\mathbf{k},n)\right)_j\frac{\partial f(E(\mathbf{k},n),E_F,T)}{\partial E}d^3\mathbf{k}}{\sum\limits_{E>E_F}\int\limits_{B.Z.}f(E(\mathbf{k},n),E_F,T)d^3\mathbf{k}}$$

for electrons and:

$$\mathbf{M}_{h,ij}^{-1}(E_F,T) = \frac{-\sum\limits_{E<E_F}\int\limits_{B.Z.}\left(\nabla_{\mathbf{k}}E(\mathbf{k},n)\right)_i\left(\nabla_{\mathbf{k}}E(\mathbf{k},n)\right)_j\frac{\partial f(E(\mathbf{k},n),E_F,T)}{\partial E}d^3\mathbf{k}}{\sum\limits_{E<E_F}\int\limits_{B.Z.}(1-f(E(\mathbf{k},n),E_F,T))d^3\mathbf{k}}$$

for holes, where *f* is the Fermi-Dirac distribution, $E_F$ is the Fermi energy, T is the temperature, E(k,n) is the energy of an electron in the state corresponding to wave vector **k** and the nth energy band, the indices i and j refer to Cartesian coordinates x, y and z, the integrals are taken over the Brillouin zone (B.Z.), and the summations are taken over bands with energies above and below the Fermi energy for electrons and holes respectively.

Applicants' definition of the conductivity reciprocal effective mass tensor is such that a tensorial component of the conductivity of the material is greater for greater values of the corresponding component of the conductivity reciprocal effective mass tensor. Again Applicants theorize without wishing to be bound thereto that the superlattices described herein set the values of the conductivity reciprocal effective mass tensor so as to enhance the conductive properties of the material, such as typically for a preferred direction of charge carrier transport. The inverse of the appropriate tensor element is referred to as the conductivity effective mass. In other words, to characterize semiconductor material structures, the conductivity effective mass for electrons/holes as described above and calculated in the direction of intended carrier transport is used to distinguish improved materials.

Applicants have identified improved materials or structures for use in semiconductor devices. More specifically, the Applicants have identified materials or structures having energy band structures for which the appropriate conductivity effective masses for electrons and/or holes are substantially less than the corresponding values for silicon. In addition to the enhanced mobility characteristics of these structures, they may also be formed or used in such a manner that they provide piezoelectric, pyroelectric, and/or ferroelectric properties that are advantageous for use in a variety of different types of devices, as will be discussed further below.

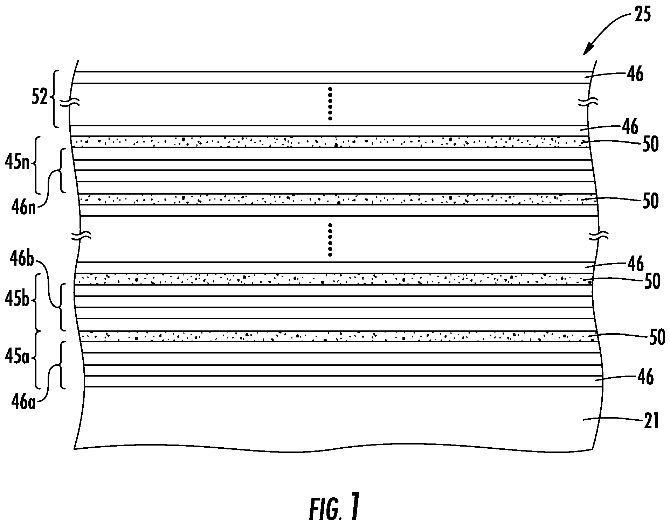

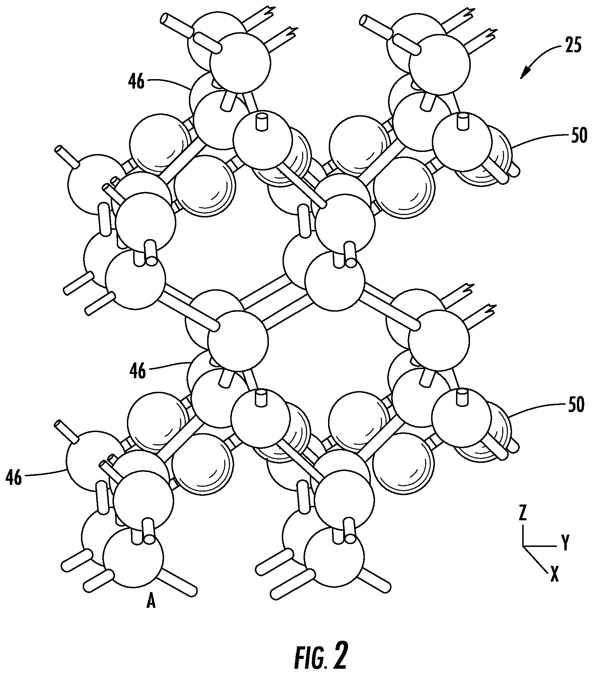

Referring now to FIGS. 1 and 2, the materials or structures are in the form of a superlattice **25** whose structure is controlled at the atomic or molecular level and may be formed using known techniques of atomic or molecular layer deposition. The superlattice **25** includes a plurality of layer groups **45a-45n** arranged in stacked relation, as perhaps best understood with specific reference to the schematic cross-sectional view of FIG. 1.

Each group of layers **45a-45n** of the superlattice **25** illustratively includes a plurality of stacked base semiconductor monolayers **46** defining a respective base semiconductor portion **46a-46n** and an energy band-modifying layer **50** thereon. The energy band-modifying layers **50** are indicated by stippling in FIG. 1 for clarity of illustration.

The energy band-modifying layer **50** illustratively includes one non-semiconductor monolayer constrained within a crystal lattice of adjacent base semiconductor portions. By "constrained within a crystal lattice of adjacent base semiconductor portions" it is meant that at least some semiconductor atoms from opposing base semiconductor portions **46a-46n** are chemically bound together through the non-semiconductor monolayer **50** therebetween, as seen in FIG. 2. Generally speaking, this configuration is made possible by controlling the amount of non-semiconductor material that is deposited on semiconductor portions **46a-46n** through atomic layer deposition techniques so that not all (i.e., less than full or 100% coverage) of the available semiconductor bonding sites are populated with bonds to non-semiconductor atoms, as will be discussed further below. Thus, as further monolayers **46** of semiconductor material are deposited on or over a non-semiconductor monolayer **50,** the newly deposited semiconductor atoms will populate the remaining vacant bonding sites of the semiconductor atoms below the non-semiconductor monolayer.

In other embodiments, more than one such non-semiconductor monolayer may be possible. It should be noted that reference herein to a non-semiconductor or semiconductor monolayer means that the material used for the monolayer would be a non-semiconductor or semiconductor if formed in bulk. That is, a single monolayer of a material, such as silicon, may not necessarily exhibit the same properties that it would if formed in bulk or in a relatively thick layer, as will be appreciated by those skilled in the art.

Applicants theorize without wishing to be bound thereto that energy band-modifying layers **50** and adjacent base semiconductor portions **46a-46n** cause the superlattice **25** to have a lower appropriate conductivity effective mass for the charge carriers in the parallel layer direction than would otherwise be present. Considered another way, this parallel direction is orthogonal to the stacking direction. The band modifying layers **50** may also cause the superlattice **25** to have a common energy band structure, while also advantageously functioning as an insulator between layers or regions vertically above and below the superlattice.

Moreover, this superlattice structure may also advantageously act as a barrier to dopant and/or material diffusion between layers vertically above and below the superlattice **25**. These properties may thus advantageously allow the superlattice **25** to provide an interface for high-K dielectrics which not only reduces diffusion of the high-K material into the channel region, but which may also advantageously reduce unwanted scattering effects and improve device mobility, as will be appreciated by those skilled in the art.

It is also theorized that semiconductor devices including the superlattice **25** may enjoy a higher charge carrier mobility based upon the lower conductivity effective mass than would otherwise be present. In some embodiments, and as a result of the band engineering achieved by the present invention, the superlattice **25** may further have a substantially direct energy bandgap that may be particularly advantageous for opto-electronic devices, for example.

The superlattice **25** also illustratively includes a cap layer **52** on an upper layer group **45n**. The cap layer **52** may comprise a plurality of base semiconductor monolayers **46**. The cap layer **52** may have between 2 to 100 monolayers of the base semiconductor, and, more preferably between 10 to 50 monolayers.

Each base semiconductor portion **46a-46n** may comprise a base semiconductor selected from the group consisting of Group IV semiconductors, Group III-V semiconductors, and Group II-VI semiconductors. Of course, the term Group IV semiconductors also includes Group IV-IV semiconductors, as will be appreciated by those skilled in the art. More particularly, the base semiconductor may comprise at least one of silicon and germanium, for example.

Each energy band-modifying layer **50** may comprise a non-semiconductor selected from the group consisting of oxygen, nitrogen, fluorine, carbon and carbon-oxygen, for example. The non-semiconductor is also desirably thermally stable through deposition of a next layer to thereby facilitate manufacturing. In other embodiments, the non-semiconductor may be another inorganic or organic element or compound that is compatible with the given semiconductor processing as will be appreciated by those skilled in the art. More particularly, the base semiconductor may comprise at least one of silicon and germanium, for example.

It should be noted that the term monolayer is meant to include a single atomic layer and also a single molecular layer. It is also noted that the energy band-modifying layer **50** provided by a single monolayer is also meant to include a monolayer wherein not all of the possible sites are occupied (i.e., there is less than full or 100% coverage). For example, with particular reference to the atomic diagram of FIG. 2, a 4/1 repeating structure is illustrated for silicon as the base semiconductor material, and oxygen as the energy band-modifying material. Only half of the possible sites for oxygen are occupied in the illustrated example.

In other embodiments and/or with different materials this one-half occupation would not necessarily be the case as will be appreciated by those skilled in the art. Indeed it can be seen even in this schematic diagram, that individual atoms of oxygen in a given monolayer are not precisely aligned along a flat plane as will also be appreciated by those of skill in the art of atomic deposition. By way of example, a preferred occupation range is from about one-eighth to one-half of the possible oxygen sites being full, although other numbers may be used in certain embodiments.

Silicon and oxygen are currently widely used in conventional semiconductor processing, and, hence, manufacturers will be readily able to use these materials as described herein. Atomic or monolayer deposition is also now widely used. Accordingly, semiconductor devices incorporating the superlattice **25** in accordance with the invention may be readily adopted and implemented, as will be appreciated by those skilled in the art.

It is theorized without Applicants wishing to be bound thereto that for a superlattice, such as the Si/O superlattice, for example, that the number of silicon monolayers should desirably be seven or less so that the energy band of the superlattice is common or relatively uniform throughout to achieve the desired advantages. The 4/1 repeating structure shown in FIGS. 1 and 2, for Si/O has been modeled to indicate an enhanced mobility for electrons and holes in the X direction. For example, the calculated conductivity effective mass for electrons (isotropic for bulk silicon) is 0.26 and for the 4/1 SiO superlattice in the X direction it is 0.12 resulting in a ratio of 0.46. Similarly, the calculation for holes yields values of 0.36 for bulk silicon and 0.16 for the 4/1 Si/O superlattice resulting in a ratio of 0.44.

While such a directionally preferential feature may be desired in certain semiconductor devices, other devices may benefit from a more uniform increase in mobility in any direction parallel to the groups of layers. It may also be beneficial to have an increased mobility for both electrons and holes, or just one of these types of charge carriers as will be appreciated by those skilled in the art.

The lower conductivity effective mass for the 4/1 Si/O embodiment of the superlattice **25** may be less than two-thirds the conductivity effective mass than would otherwise occur, and this applies for both electrons and holes. Of course, the superlattice **25** may further comprise at least one type of conductivity dopant therein, as will also be appreciated by those skilled in the art.

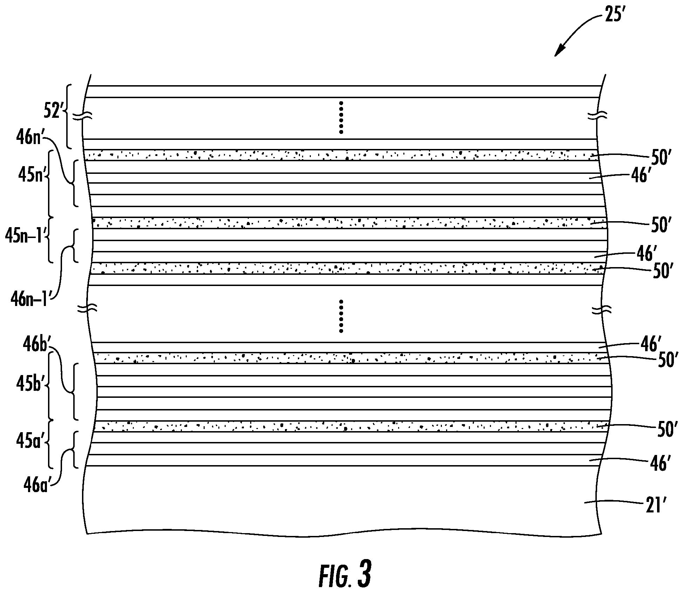

Indeed, referring now additionally to FIG. 3, another embodiment of a superlattice **25'** in accordance with the invention having different properties is now described. In this embodiment, a repeating pattern of 3/1/5/1 is illustrated. More particularly, the lowest base semiconductor portion **46a'** has three monolayers, and the second lowest base semiconductor portion **46b'** has five monolayers. This pattern repeats throughout the superlattice **25'**. The energy band-modifying layers **50'** may each include a single monolayer. For such a superlattice **25'** including Si/O, the enhancement of charge carrier mobility is independent of orientation in the plane of the layers. Those other elements of FIG. 3 not specifically mentioned are similar to those discussed above with reference to FIG. 1 and need no further discussion herein.

In some device embodiments, all of the base semiconductor portions of a superlattice may be a same number of monolayers thick. In other embodiments, at least some of the base semiconductor portions may be a different number of monolayers thick. In still other embodiments, all of the base semiconductor portions may be a different number of monolayers thick.

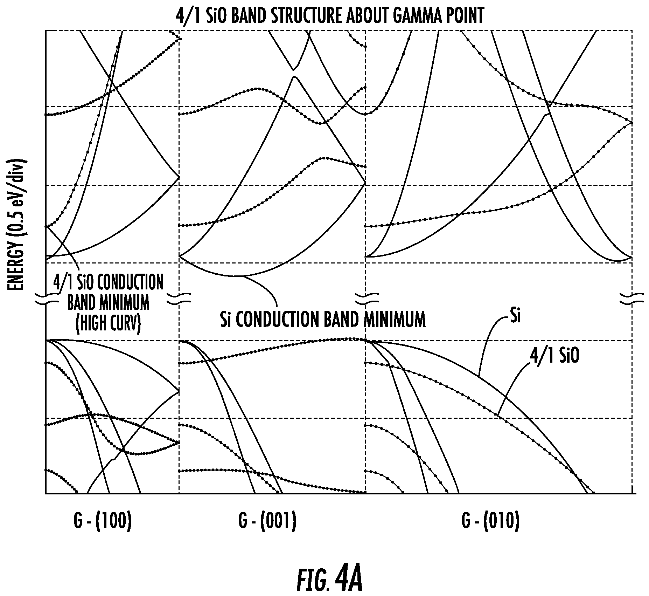

In FIGS. 4A-4C, band structures calculated using Density Functional Theory (DFT) are presented. It is well known in the art that DFT underestimates the absolute value of the bandgap. Hence all bands above the gap may be shifted by an appropriate "scissors correction." However the shape of the band is known to be much more reliable. The vertical energy axes should be interpreted in this light.

FIG. 4A shows the calculated band structure from the gamma point (G) for both bulk silicon (represented by continuous lines) and for the 4/1 Si/O superlattice **25** shown in FIG. 1 (represented by dotted lines). The directions refer to the unit cell of the 4/1 Si/O structure and not to the conventional unit cell of Si, although the (001) direction in the figure does correspond to the (001) direction of the conventional unit cell of Si, and, hence, shows the expected location of the Si conduction band minimum. The (100) and (010) directions in the figure correspond to the (110) and (-110) directions of the conventional Si unit cell. Those skilled in the art will appreciate that the bands of Si on the figure are folded to represent them on the appropriate reciprocal lattice directions for the 4/1 Si/O structure.

It can be seen that the conduction band minimum for the 4/1 Si/O structure is located at the gamma point in contrast to bulk silicon (Si), whereas the valence band minimum occurs at the edge of the Brillouin zone in the (001) direction which we refer to as the Z point. One may also note the greater curvature of the conduction band minimum for the 4/1 Si/O structure compared to the curvature of the conduction band minimum for Si owing to the band splitting due to the perturbation introduced by the additional oxygen layer.

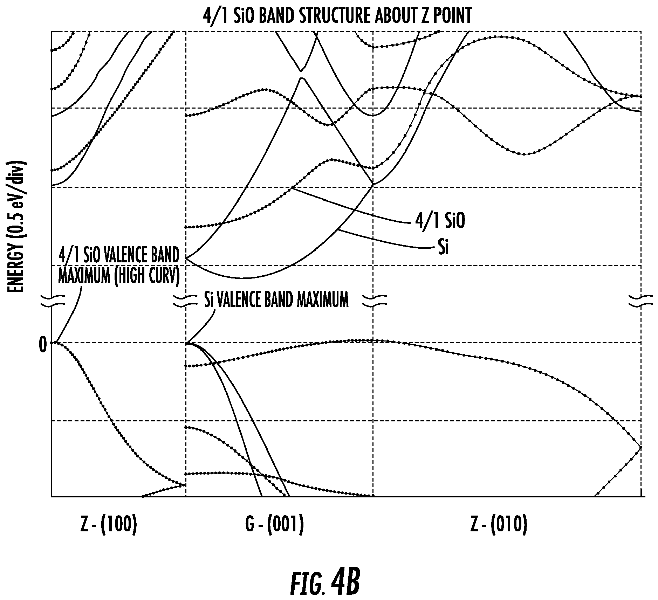

FIG. 4B shows the calculated band structure from the Z point for both bulk silicon (continuous lines) and for the 4/1 Si/O superlattice **25** (dotted lines). This figure illustrates the enhanced curvature of the valence band in the (100) direction.

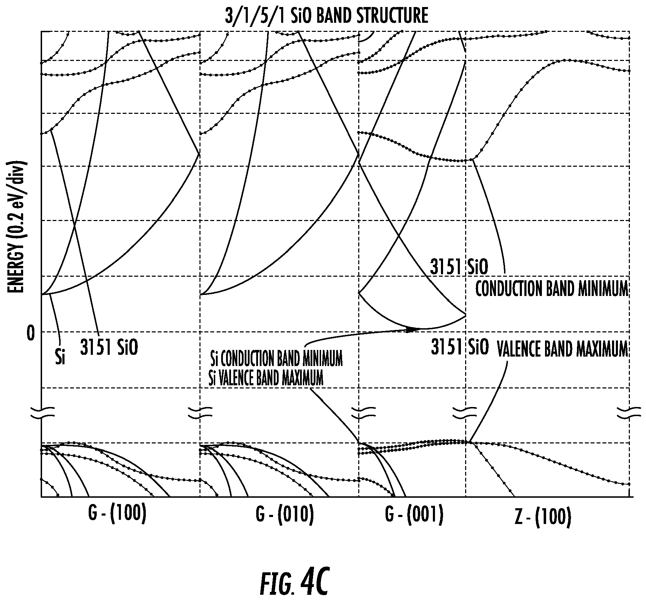

FIG. 4C shows the calculated band structure from both the gamma and Z point for both bulk silicon (continuous lines) and for the 5/1/3/1 Si/O structure of the superlattice **25'** of FIG. 3 (dotted lines). Due to the symmetry of the 5/1/3/1 Si/O structure, the calculated band structures in the (100) and (010) directions are equivalent. Thus the conductivity effective mass and mobility are expected to be isotropic in the plane parallel to the layers, i.e. perpendicular to the (001) stacking direction. Note that in the 5/1/3/1 Si/O example the conduction band minimum and the valence band maximum are both at or close to the Z point.

Although increased curvature is an indication of reduced effective mass, the appropriate comparison and discrimination may be made via the conductivity reciprocal effective mass tensor calculation. This leads Applicants to further theorize that the 5/1/3/1 superlattice **25'** should be substantially direct bandgap. As will be understood by those skilled in the art, the appropriate matrix element for optical transition is another indicator of the distinction between direct and indirect bandgap behavior.

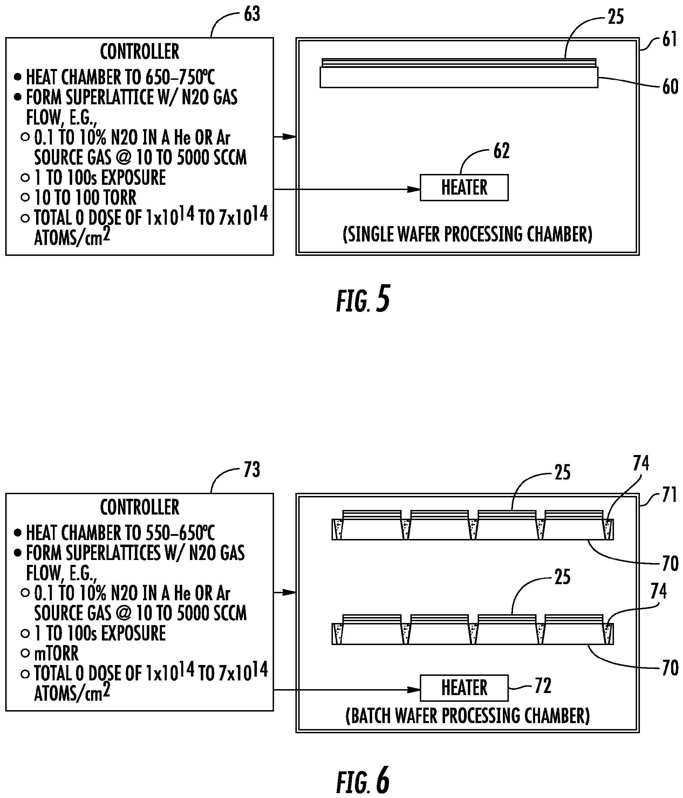

Turning to FIGS. 5-11, example approaches for fabricating band-engineered structures or films such as those described above using an $N_2O$ oxygen delivery system in both single wafer (FIG. 5) and batch (FIG. 6) processing chambers to enhance yield are now described. In the single wafer approach, a semiconductor (e.g., silicon) wafer **60** may be inserted in a single wafer chamber **61** which illustratively includes a heater or heating element(s) **62**. Moreover, a controller **63** may control the heater **62**, gas flow, and other operations within the chamber **61** during processing to perform a blanket superlattice **25** deposition on the wafer **60**. That is, the superlattice **25** is formed across the entire upper surface of the wafer **60**. However, in some embodiments a selective deposition approach may be used, in which superlattice **25** layers or films are selectively formed on active areas of the wafer **60** after shallow trench isolation (STI) region formation, as will be discussed further below with respect to FIG. 6. Either blanket or selective superlattice deposition may be performed in the single wafer chamber **61** using the techniques described herein.

One example single wafer chamber **61** is a single wafer Advanced Semiconductor Materials (ASM) chamber in which operation at a reduced pressure (RP) may be achieved, e.g., in a range of 10T to 100T, and more particularly about 19T-40T. By way of comparison, in a typical approach for making an Si/O superlattice **25**, a 1% $O_2$ gas flow in a He gas source may be used in the ASM processing chamber. In an example embodiment, an $N_2O$ oxygen source in used instead of $O_2$. More particularly, the controller **63** may provide for a $N_2O$ gas flow in a range of 0.1% to 10%, and more particularly around 1%, in a He or Ar gas source as a replacement to the above-noted $O_2$ gas flow. Generally speaking, $N_2O$ is less reactive than $O_2$, and accordingly may be advantageous in some applications to help control the fabrication process, as will be discussed further below.

Example processing parameters will now be described for using the above-noted $N_2O$ gas flow in the single wafer chamber **61**. The chamber may be heated to a temperature in a range of 650 to 700°C, for example. Applicants have determined that below 650°C, little or no oxygen will be incorporated into an Si/O superlattice film **25** with the $N_2O$ gas flow. Moreover, above 700°C, oxygen may be incorporated but silicon growth post oxygen deposition may be reduced, presumably because a different state of incorporation is starting to dominate. In the selective deposition approach, for example, $SiO_2$ may be formed on the surface, which results in the lower Si growth rate.

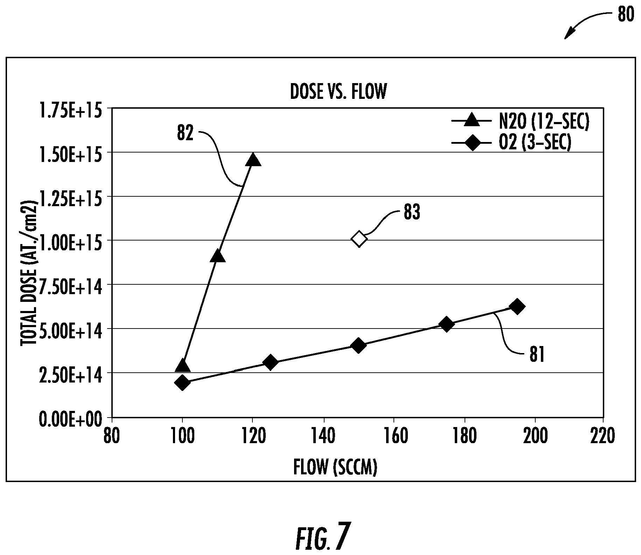

Furthermore, the $N_2O$ gas flows may range from 10 to 5000 SCCM, and more particularly about 80 to 195 SCCM, and dose times may be in a range from 10 to 100 seconds, and more particularly about 12 to 24 seconds, for example. This may correspond to a total dose of about $1\times10^{14}$ to $7\times10^{14}$ atoms/cm$^2$, as shown in the plot line **81** of the graph **80** of FIG. 7, which is for a 680°C single wafer process. By way of comparison, the plot line **82** corresponds to an $O_2$ gas flow, which only requires a three second exposure time due to the greater reactivity than $N_2O$. It may be seen that the twelve second $N_2O$ exposure is 4x longer, and the tuning curve is flatter. In this comparison, adjustments were made to the overall process pressure to get one point **83** (while keeping temperature, time, and flow rates the same as the point below it) for $N_2O$ that centered the process around $1\times10^{15}$ atoms/cm$^2$. Applicant theorizes, without wishing to be bound thereto, that dose retention and pile up results may be similar for superlattice films having oxygen monolayers deposited using $N_2O$ to those with oxygen layers deposited using $O_2$ gas flows.

In the example of FIG. 6, useful for understanding the invention, a plurality of wafers **70** are processed in a batch reactor **71** with a heater **72**. Here again, a controller **73** illustratively controls the heater **72**, the gas flow, etc., during batch processing to form superlattices **25** on the wafers **70**. In the illustrated example, a selective process is performed in which respective superlattices are formed between adjacent STI regions **74** in the wafers **70**, as noted above, although a blanket film deposition may also be performed in different embodiments.

By way of example, such batch processing of semiconductor devices or wafers including the above-described structures may be performed using the Batch Epitaxial System (BES) from Hitachi Kokusai Electric (HKE), Inc. of Tokyo, Japan. The BES operates in the mTorr regime, and is a large furnace design. By way of example, an example batch may include 50 to 125 semiconductor wafers, although other numbers of wafers may be processed in different embodiments. Moreover, different processing chambers may be used in addition to the example chambers referenced herein.

While $N_2O$ is advantageously less reactive than $O_2$ and may therefore help with controlling the batch fabrication process (to get better uniformity), various processing parameters may be selected to allow the $N_2O$ to be sufficiently reactive to allow formation of the above-described superlattice films. For example, temperature may be increased to get an oxygen source to react, yet without making it so high that the oxygen either desorbs before the next silicon layer is put down, or the oxygen bonds in a different configuration ($SiO_2$) and prevents the restart of silicon epitaxial growth altogether. Generally speaking, batch processing at lower pressure makes the gases more reactive, and thus the above-noted parameters provided for the single wafer processing may be used for batch processing, but with temperatures translated down to 550-600°C to provide comparable reactivity in a mTorr regime. Both the single wafer and batch processing may be selective or non-selective using dichlorosilane (DCS), for example. The DCS may be used at the higher temperatures and is selective with the addition of HCl. However, other temperature ranges may be used in different configurations.

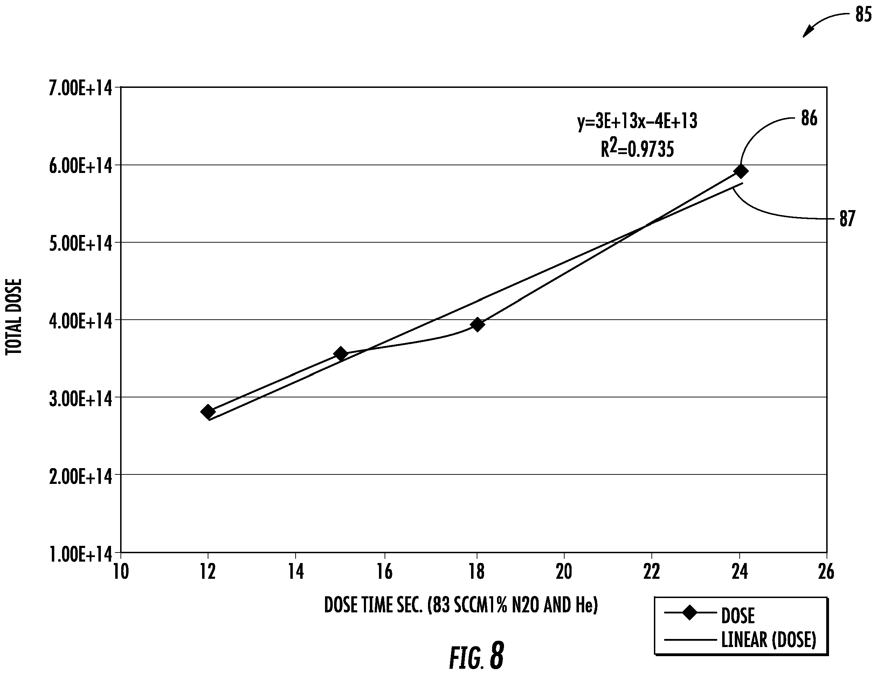

In the graph **85** of FIG. 8, total dose vs. time for a 1% $N_2O$ gas flow in an ASM single wafer chamber is represented by the plot **86** for a 650°C deposition and 83 SCCM. From the reference plot **87** may be seen that the total dose is essentially linear. By way of comparison, on this scale oxygen would be at $1\times10^{15}$ atoms/cm$^2$ for an exposure down at 3 seconds.

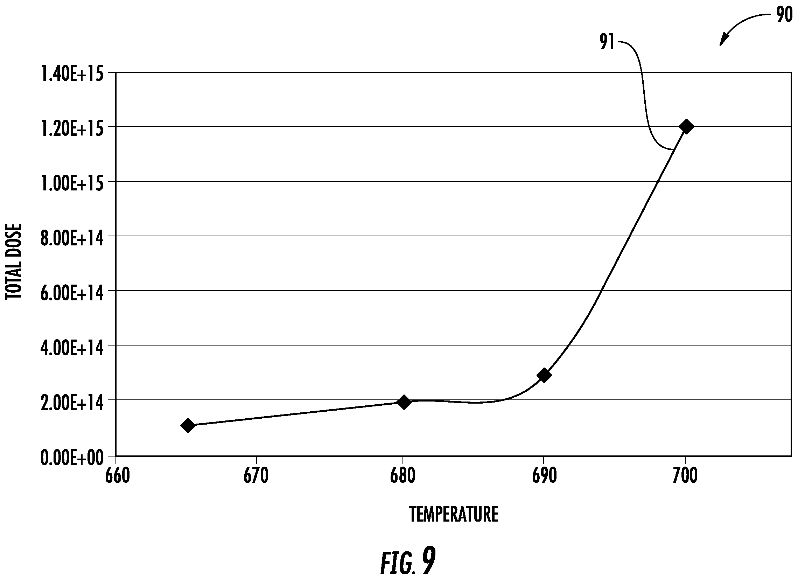

In the graph **90** of FIG. 9, total dose vs. temperature is illustrated by the plot **91** for the 1% $N_2O$ gas flow in a single wafer chamber. As noted above, oxygen incorporation is not repeatable near (and below) 650°C (i.e., no $N_2O$ decomposition), and is unstable above 700°C (i.e., there is a change in oxygen bonding to silicon) for the ASM single wafer platform.

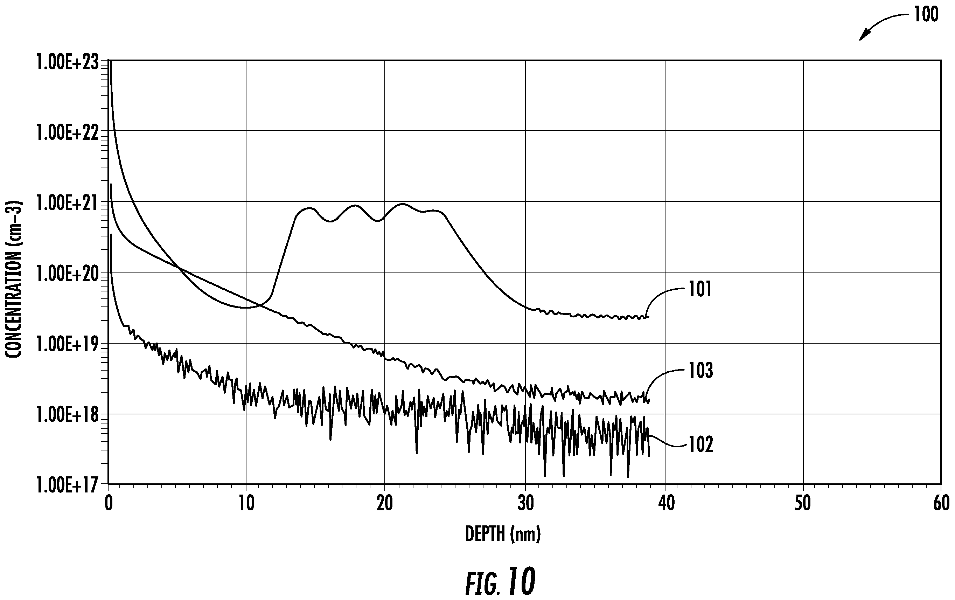

Referring additionally to FIG. 10, the graph **100** illustrates concentrations vs. depth for a selective superlattice deposition (i.e., between adjacent STI regions) with a relatively wide spacing using 30Å spacers and grown using $N_2O$ in the single wafer ASM chamber. In the illustrated example, oxygen concentration is represented by the plot **101,** SiN concentration is represented by the plot **102,** and carbon-12 is represented by the plot line **103**. For this example, an $N_2O$ exposure for 12 seconds at 680°C and 170 SCCM was used.

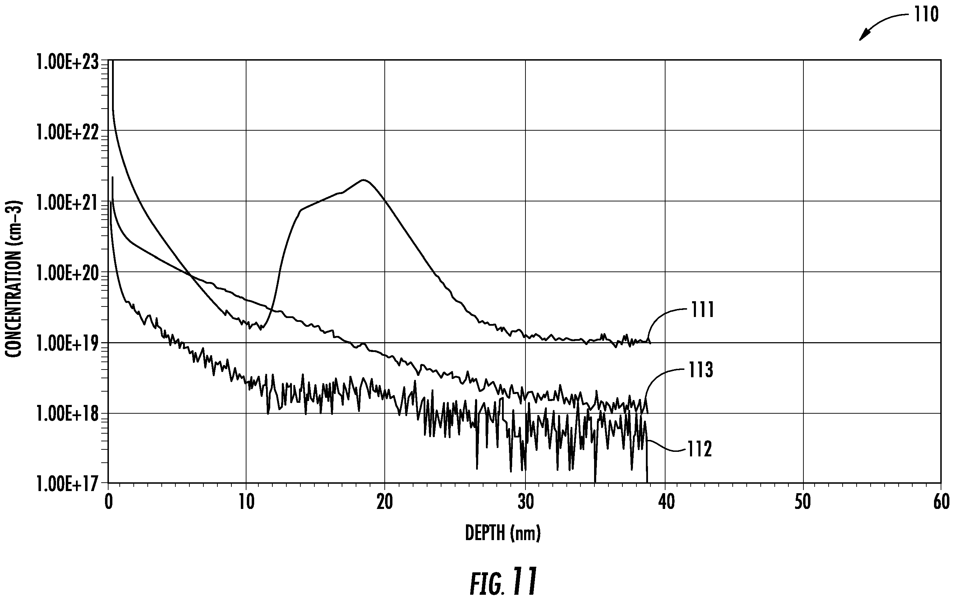

Another similar example is provided in the graph **110** of FIG. 11. Here, everything is the same as in the example of FIG. 10, except that smaller spacers (i.e., 16Å) were used. Here, the oxygen concentration is represented by the plot **111**, SiN concentration is represented by the plot **112**, and carbon-12 is represented by the plot line **113**.

## Claims

1. A method for processing a semiconductor wafer (60) in a wafer processing chamber (61), the method comprising:

   heating the wafer processing chamber (61); and
   forming at least one superlattice (25) on the semiconductor wafer (60) within the heated single wafer processing chamber (61) by depositing silicon and oxygen to form a plurality of stacked groups of layers with each group of layers comprising a plurality of stacked base silicon monolayers defining a base silicon portion and at least one oxygen monolayer constrained within a crystal lattice of adjacent base silicon portions;
   **characterised in that**
   the wafer processing chamber is a single wafer processing chamber; the chamber is heated to a temperature in a range of 650-700°C; and
   depositing the oxygen comprises depositing the oxygen using an $N_2O$ gas flow.

2. The method of Claim 1 wherein the $N_2O$ gas flow comprises 0.1% to 10% $N_2O$ in a gas comprising at least one of He and Ar.

3. The method of Claim 1 wherein depositing the oxygen comprises depositing the oxygen with an exposure time in a range of 1 to 100 seconds.

4. The method of Claim 1 wherein the $N_2O$ gas flow is in a range of 10 to 5000 standard cubic centimeters per minute (SCCM).

5. The method of Claim 1 wherein depositing the oxygen comprises depositing the oxygen at a pressure in a range of 10 to 100 Torr.

6. The method of Claim 1 wherein a total dose of $N_2O$ is in a range of $1x10^{14}$ to $7x10^{14}$ atoms/cm$^2$ during the oxygen monolayer formation.

7. The method of Claim 1 wherein the semiconductor wafer comprises a plurality of spaced apart shallow trench isolation (STI) regions, and wherein forming the at least one superlattice comprises selectively forming a respective superlattice between adjacent pairs of STI regions.

8. The method of Claim 1 wherein forming the at least one superlattice (25) comprises a blanket superlattice formation on the semiconductor wafer (60).

9. The method of Claim 1 wherein at least some silicon atoms from opposing base silicon portions are chemically bound together through the at least one oxygen monolayer therebetween.

## Patentansprüche

1. Verfahren zum Bearbeiten eines Halbleiter-Wafers (60) in einer Wafer-Bearbeitungskammer (61), wobei das Verfahren aufweist:

   Aufheizen der Wafer-Bearbeitungskammer (61) und
   Bilden wenigstens einer Überstruktur (25) auf dem Halbleiter-Wafer (60) in der aufgeheizten Wafer-Bearbeitungskammer (61) durch Abscheiden von Silicium und Sauerstoff, um mehrere gestapelte Gruppen von Schichten zu bilden, wobei jede Schichtengruppe mehrere gestapelte Basis-Silicium-Monoschichten, die einen Basis-Siliciumabschnitt definieren, und wenigstens eine Sauerstoff-Monoschicht, die in einem Kristallgitter von benachbarten Basis-Siliciumabschnitten eingezwängt ist, aufweist,

**dadurch gekennzeichnet, dass**

die Wafer-Bearbeitungskammer eine Ein-Wafer-Bearbeitungskammer ist;

die Kammer auf eine Temperatur im Bereich von 650-700°C aufgeheizt wird; und

das Abscheiden des Sauerstoffs ein Abscheiden des Sauerstoffs unter Verwendung eines $N_2O$-Gasstroms aufweist.

2. Verfahren nach Anspruch 1, bei welchem der $N_2O$-Gasstrom 0,1% bis 10% $N_2O$ in einem Gas mit He und/oder Ar aufweist.

3. Verfahren nach Anspruch 1, bei welchem das Abscheiden des Sauerstoffs ein Abscheiden des Sauerstoffs mit einer Einwirkungsdauer in einem Bereich von 1 bis 100 Sekunden aufweist.

4. Verfahren nach Anspruch 1, bei welchem der $N_2O$-Gasstrom in einem Bereich von 10 bis 5000 Normkubikzentimeter pro Minute (SCCM) liegt.

5. Verfahren nach Anspruch 1, bei welchem das Abscheiden des Sauerstoffs ein Abscheiden des Sauerstoffs bei einem Druck im Bereich von 10 bis 100 Torr aufweist.

6. Verfahren nach Anspruch 1, bei welchem eine Gesamtdosis von $N_2O$ während der Sauerstoff-Monoschichtbildung in einem Bereich von $1 \times 10^{14}$ bis $7 \times 10^{14}$ Atomen / cm$^2$ liegt.

7. Verfahren nach Anspruch 1, bei welchem der Halbleiter-Wafer mehrere voneinander beabstandete Grabenisolations (STI) - Bereiche aufweist, und bei welchem das Bilden der wenigstens einen Überstruktur ein selektives Bilden einer jeweiligen Überstruktur zwischen benachbarten Paaren von STI-Bereichen aufweist.

8. Verfahren nach Anspruch 1, bei welchem das Bilden der wenigstens einen Überstruktur (25) eine abdeckende Überstrukturbildung auf dem Halbleiter-Wafer (60) aufweist.

9. Verfahren nach Anspruch 1, bei welchem wenigstens ein paar Siliciumatome von gegenüberliegenden Basis-Siliciumabschnitten durch die wenigstens eine Sauerstoffmonoschicht dazwischen chemisch miteinander verbunden werden.

**Revendications**

1. Procédé de traitement d'un wafer de matériau semi-conducteur (60) dans une chambre de traitement de wafer (61), le procédé consistant à :

chauffer la chambre de traitement de wafer (61) ; et

former au moins un super réseau (25) sur le wafer de matériau semi-conducteur (60) à l'intérieur de la chambre de traitement de wafer (61) chauffée, en déposant du silicium et de l'oxygène pour former une pluralité de groupes empilés de couches avec chaque groupe de couches comprenant une pluralité de monocouches de silicium de base empilées définissant une partie en silicium de base, et au moins une monocouche d'oxygène contrainte à l'intérieur d'un réseau cristallin de parties de silicium de base adjacentes ;

**caractérisé en ce que**

la chambre de traitement de wafer est une chambre de traitement de wafer unique, la chambre étant chauffée à une température se situant dans une plage allant de 650 à 700 °C ; et

l'étape de déposer de l'oxygène consiste à déposer de l'oxygène en utilisant un flux de gaz $N_2O$.

2. Procédé selon la revendication 1, dans lequel le flux de gaz $N_2O$ comprend de 0,1 % à 10 % de $N_2O$ dans un gaz comprenant au moins l'un parmi He et Ar.

3. Procédé selon la revendication 1, dans lequel l'étape de déposer de l'oxygène consiste à déposer de l'oxygène avec un temps d'exposition se situant dans une plage allant de 1 à 100 secondes.

**4.** Procédé selon la revendication 1, dans lequel le flux de gaz N$_2$O se situe dans une plage allant de 10 à 5000 centimètres cubes standard par minute (SCCM).

**5.** Procédé selon la revendication 1, dans lequel l'étape de déposer de l'oxygène consiste à déposer de l'oxygène à une pression se situant dans une plage allant de 10 à 100 Torr.

**6.** Procédé selon la revendication 1, dans lequel une dose totale de N$_2$O se situe dans une plage allant de 1 x 10$^{14}$ à 7 x 10$^{14}$ atomes/cm$^2$ durant la formation de la monocouche d'oxygène.

**7.** Procédé selon la revendication 1, dans lequel le wafer de matériau semi-conducteur comprend une pluralité de régions d'isolation de tranchées peu profondes (STI) qui sont espacées entre elles, et dans lequel l'étape de former ledit au moins un super réseau consiste à former de manière sélective un super réseau respectif entre des paires adjacentes de régions STI.

**8.** Procédé selon la revendication 1, dans lequel l'étape de former ledit au moins un super réseau (25) comprend une formation de couverture de super réseau sur le wafer de matériau semi-conducteur (60).

**9.** Procédé selon la revendication 1, dans lequel au moins certains atomes de silicium de parties de silicium de base opposées sont liés chimiquement ensemble via ladite au moins une monocouche d'oxygène se trouvant entre eux.

FIG. 1

**FIG. 2**

FIG. 3

4/1 SiO BAND STRUCTURE ABOUT GAMMA POINT

ENERGY (0.5 eV/div)

4/1 SiO CONDUCTION BAND MINIMUM (HIGH CURV)

Si CONDUCTION BAND MINIMUM

Si

4/1 SiO

G - (100)          G - (001)          G - (010)

*FIG.* 4A

FIG. 4B

3/1/5/1 SiO BAND STRUCTURE

FIG. 4C

63

CONTROLLER
- HEAT CHAMBER TO 650–750°C
- FORM SUPERLATTICE W/ N2O GAS
  FLOW, E.G.,
  ○ 0.1 TO 10% N2O IN A He OR Ar
    SOURCE GAS @ 10 TO 5000 SCCM
  ○ 1 TO 100s EXPOSURE
  ○ 10 TO 100 TORR
  ○ TOTAL O DOSE OF $1 \times 10^{14}$ TO $7 \times 10^{14}$
    ATOMS/$cm^2$

25
61
60
62
HEATER
(SINGLE WAFER PROCESSING CHAMBER)

*FIG. 5*

73

CONTROLLER
- HEAT CHAMBER TO 550–650°C
- FORM SUPERLATTICES W/ N2O GAS
  FLOW, E.G.,
  ○ 0.1 TO 10% N2O IN A He OR Ar
    SOURCE GAS @ 10 TO 5000 SCCM
  ○ 1 TO 100s EXPOSURE
  ○ mTORR
  ○ TOTAL O DOSE OF $1 \times 10^{14}$ TO $7 \times 10^{14}$
    ATOMS/$cm^2$

25
74
71
70
25
74
70
HEATER 72
(BATCH WAFER PROCESSING CHAMBER)

*FIG. 6*

*FIG. 7*

*FIG. 8*

EP 3 295 484 B1

FIG. 9

*FIG. 10*

EP 3 295 484 B1

*FIG. 11*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030057416 A, Currie
- US 20030034529 A, Fitzgerald
- US 6472685 B2, Takagi
- US 4937204 A, Ishibashi
- US 5357119 A, Wang
- US 5683934 A, Candelaria
- US 5216262 A, Tsu
- WO 02103767 A1, Wang, Tsu and Lofgren
- GB 2347520 A, Mears
- US 2007197006 A1

**Non-patent literature cited in the description**

- **TSU.** Phenomena in silicon nanostructure devices. *Applied Physics and Materials Science & Processing,* 06 September 2000, 391-402
- **LUO et al.** Chemical Design of Direct-Gap Light-Emitting Silicon. *Physical Review Letters,* 12 August 2002, vol. 89 (7